Europäisches Patentamt

European Patent Office

Office européen des brevets

(11) Publication number: **0 270 983**
**A2**

# (12) EUROPEAN PATENT APPLICATION

(21) Application number: **87117758.0**

(22) Date of filing: **01.12.87**

(51) Int. Cl.⁴: **G06F 9/44** , G06F 9/46 ,
G06F 11/34

(30) Priority: **08.12.86 US 938937**

(43) Date of publication of application:
**15.06.88 Bulletin 88/24**

(84) Designated Contracting States:
**DE FR GB**

(71) Applicant: **International Business Machines
Corporation
Old Orchard Road
Armonk, N.Y. 10504(US)**

(72) Inventor: **Darema-Rogers, Frederica
104 Cleveland Drive
Croton-on-Hudson, N.Y. 10520(US)**
Inventor: **George, David Alson
Arthur Court
Somers, N.Y. 10589(US)**
Inventor: **Melton, Evelyn Au
20 Rothenburg Rd.
Poughkeepsie, N.Y. 12603(US)**
Inventor: **Norton, Vern Alan
117 Old Post Road South
Croton-on-Hudson, N.Y. 10520(US)**
Inventor: **Pfister, Gregory Francis
251 Prince Court
Yorktown Heights, N.Y. 10598(US)**
Inventor: **So, Kimming
10 Hunter Drive
Armonk, N.Y. 10504(US)**

(74) Representative: **Teufel, Fritz, Dipl.-Phys. et al
IBM Deutschland GmbH. Europäische
Patentdienste Postfach 265
D-8000 München 22(DE)**

(54) Method for the parallel simulation of multiprocessor computer systems.

(57) A method for speeding up the simulation of the execution of parallel programs running on multiprocessor (MP) systems. It provides a user with the performance statistics and MP traces of parallel programs. These can further be used to study in detail the characteristics, memory access patterns of parallel programs, or to drive a memory-network simulation model of an MP system. The method comprises breaking the sequential process of MP simulation into a group of cooperating processes running on a multiprogrammed system with each process simulating one processor. The processes are very independent of each other, therefore a speedup of simulation is achieved if the multiprogrammed system is itself running on an MP system.

# FIG.4

A PARALLEL SIMULATION OF MP COMPUTER SYSTEMS

| APPLICATION SYSTEM | ← 300 |

CPU 1    CPU 2  ----------  CPU n    ~220

SIMULATING PROGRAM 1    SIMULATING PROGRAM 2  ---  SIMULATING PROGRAM n    ~210

200 PARALLEL SIMULATOR

BASE OPERATING SYSTEM    ~120

I/O  180    I/O  ----------  I/O    ~110

100 BASE SYSTEM

# METHOD FOR THE PARALLEL SIMULATION OF MULTIPROCESSOR COMPUTER SYSTEMS

## BACKGROUND OF THE INVENTION

### TECHNICAL FIELD

The present invention relates to the field of simulation or the tracing of the execution of plural simulated processors on a base data processing system. More specifically, it is directed to a method for speeding up the instruction level simulation of a multiprocessor computer system having a large shared memory through the use of a computer system with a plural number of processors.

### Background Art

As computer systems are being built with more sophisticated architectural constructs and internal assists, simulation or tracing of their execution while running real applications is increasingly important. These simulations are not used to produce the gross performance statistics such as throughput or response time, but to make close observations on the execution flow of both software and hardware - the kind of microscopic or 'realistic' information that cannot be obtained by theoretical or simulation models driven by random numbers. The purpose is thus to estimate the performance of one or many components in new computer systems being built without having to actually produce the hardware/software. The techniques although accurate, are known to be expensive and slow. The simulation of computer systems consisting of a relatively large number of CPUs, i.e., multiprocessor (MP) systems, introduces another dimension of complexity which further slows down the simulation speed because of the number of CPUs being simulated. Usually it takes many hours to simulate only a few seconds of execution in the system being simulated; and yet it is still too short to capture all of the software and hardware activities one would like to observe. Conventionally this is done by a program, called a sequential simulator in the computer arts, that simulates one instruction per CPU on a round-robin basis. For example; the WASHCLOTH parallel computer simulator described in the publication "WASHCLOTH the Logical Successor to the SOAP SUDS" by A. Gottlieb, Ultra-computer Note #12, Courant Institute NYU (Dec. 1980). Although this sequential simulator has the advantage of simplifying the simulating process and guarantees a maximum degree of load balance across all CPUs simulated, it fails to take the advantage of more than one CPU if the base system, where the simulation is performed, is already an MP system.

The following three patents are exemplary of the patent art in this area. They deal primarily with the capability or efficiency of emulating multiple operating systems (or architectures) on an existing multiprogrammed system (or architecture). None of them addresses the particular problem that is addressed by the present invention, namely simulation of a MP system, at the instruction level, by a multiprogrammed or multiprocessing system.

U.S. Patent 4,456,954 to R.J. Bullions et al sets forth a virtual machine (VM) system which emulates one or more guest architectures in a multiprogrammed system when executing plural levels of operating systems on plural levels of architecture. It discloses an efficient way of address translation across the levels.

U.S. Patent 4,392,196 to R. Glenn et al sets forth a scheme of aligning the time among the processors in a microprocessor system in the emulation of an MP system.

U.S. Patent 4,400,769 to S. Kaneda sets forth, in a VM system which is running a plurality of operating systems, a simple hardware construct in place of the conventional software control to suppress the overhead that is produced when simulating privileged instructions.

The articles referenced below relate generally to the field of simulation/emulation and are of a background nature. None are directed to the concept of running a MP simulator in parallel across all of the processors of an MP base computer system.

Virtual Storage and Dynamic Address Translation -Simulation of Various Arrangement of Three-and-half Generation Computers," by M. Vlokova, Mech. Autom. Adm. (Czechoslovakia), V. 18, No. 11, pp. 414-417, 1978 (in Czech language). This article outlines the main advantages of the virtual storage approach and discusses the principle of addressing in virtual mode. Simulation of a multiprocessing computer system with a common data bus has been carried out with the aim of obtaining the dependence of the system output on the number of operating modules and to determine the influence of inputs and outputs. The ES 10 25 system with several operational modules has been analyzed as an example, using GPSS as the simulation language. The simulation itself appears to uses straight forward sequential methods.

Nanoprogramming of a Multi-Emulator for 8 Bit-class Microcomputers," by L. Dewez et al Seventh Euromicro symposium on Microprocessing and Microprogramming, pp. 317-324, 1981. This article discusses a virtual microprogramming machine having as its objective the emulation of an 8-bit micro-MP system. The horizontal microinstructions of this virtual machine, called EM8, are interpreted by the vertical microinstructions of the multi 6 microprogrammable computer. After the estimated requirements of an 8 bit-class 'envelope' machine are set out, the architecture of the multiple emulation micromachine is discussed and microinstruction formats are proposed. The interpretation conditions on multi 6 are defined as well as the state of software conception and development of emulator management and environment communications.

SIMUL 4, A Simulator for Development and testing SMS parallel Computer Programs," by E.H. Horneber Siemens Forschungs-und Entwicklungslabor, Siemens AG, V. 9, No. 1, pp. 8-10, 1980 (German Language). This article describes the architectural principles of a parallel array processor, and outlines how the essential features have been incorporated into a simulator running on a readily-available single processor. The simulator serves both for program development and as an introduction to multiprocessing.

Since true multiprocessor systems are now generally available such as the IBM 3081 having two or more base CPUs, there is a need for utilizing this processing power more efficiently to speed up the very time consuming simulation of complex experimental multiprocessor systems.

Since true MP systems such as the IBM 3081 are now generally available, a way to speedup a simulation is to simply make use of the MP capability of a base system. The idea, called parallel simulation here, is to break up the process of a sequential simulator into a group of cooperative processes that can be simultaneously active on all of the CPUs in a base system. Therefore, in comparison to known sequential simulators, the parallel simulation system of the present invention provides a speed up factor approximately proportional to the number of CPUs in the base MP system.

## SUMMARY AND OBJECTS

It is a primary object of the present invention to provide a method for producing a significantly faster simulation and tracing of one or more application programs running on a simulated multiprocessor system.

It is a further object of the invention to provide such a method which uses a plurality of virtual processing elements in a base data processing system to simulate a plurality of processing elements in another data processing system.

It is another object of the present invention to provide such a simulation method wherein simulation speed is greatly increased by falling paralleling the operation of the individual processors in a multiprocessor base system.

It is another object of the invention to provide within the base system in which the simulation is performed, a simulating program for each processor of the simulated multiprocessor system.

It is a still further object in such a method to provide in addition to the separate simulating program for each processor a separate output device to store the performance trace generated for each simulated processor.

It is another object of the invention to provide such a simulation method wherein data sharing is allowed through the use of commonly addressable shared segments in the memory of the base system by each simulated processor.

It is another object of the invention to provide such a simulation method wherein synchronization flags are inserted into the individual components traces associated with each simulating program and related processor.

It is another object of the invention to provide such a simulation program wherein the separate simulated processors in the simulated system may be virtual nodes or processors in a multiprogrammed system.

The objects of the present invention are accomplished in general by a parallel simulation system which provides a simple but fast simulation and the tracing of one or more application programs running on a simulated multiprocessor system. This system includes executing, at a base system where the simulation is performed, a simulating program for each processor in the simulated multiprocessor system. Each simulating program simulates one processor and has its own dedicated output device to store the trace generated by the simulation so that all of the resources in the base system including a plurality of CPUs may be optimally used. Data sharing among the simulated processors is provided through a commonly addressable segment in the memory of the base system. Atomic instructions such as COMPARE SWAP (CS) (Reference: IBM 5/370 Principles of Operation, GA-227000) and FETCH ADD (F & A) (Reference: A. Gottlieb and C. Kruskal Coordination of Parallel Processors: A Partial Unificational Computer Architecture News, Oct. 1981) that are used by the simulated processors to serialize concurrent accesses to shared memory locations in the simulated multiprocessor system are guaranteed by using the atomic instructions provided at the base system. Synchronization records are inserted into the individual traces by the simulating program CPU whenever it finds that the operation in the CPU it is simulating is waiting for the completion of an operation in another simulated CPU. This means that any synchronization events among the processors in the simulated multiprocessor system are recorded. These records allow any use of the traces to recreate a full multiprocessor trace, with correct execution sequencing from the set of individual or uniprocessor traces each of which is generated by a simulating program.

## BRIEF DESCRIPTION OF THE DRAWINGS

FIG. 1 comprises an organizational diagram illustrating the environment for the simulation of a computer system.

FIG. 2 comprises an organizational diagram illustrating a basic shared memory MP system.

FIG. 3 comprises an organizational diagram illustrating a conventional prior art sequential MP simulator.

FIG. 4 comprises an organizational diagram illustrating the parallel simulation of an MP system in accordance with the teaching of the present invention.

FIG. 5 comprises an organizational diagram illustrating the operation of a simulating processing the simulation environment of FIG. 4.

FIG. 6 comprises a diagram illustrating memory allocation and usage for a simulating process.

FIG. 7 comprises a diagram illustrating memory allocation and usage for a simulated process in the simulated memory.

FIG. 8 comprises a diagram illustrating how MP synchronization events inserted in the simulating programs can be recognized in a set of uniprocessor traces.

FIG. 9 comprises a high level flow chart illustrating the procedure of preparing a parallel simulation on a multiprocessor being simulated according to the teachings of the present invention of the parallel simulation of multiprocessor comprises a high level flow chart illustrating the sequence of steps necessary to prepare for a parallel simulation of a multiprocessor system according to the teachings of the present invention.

## DESCRIPTION OF THE PREFERRED EMBODIMENT

Before describing the detailed operation of the preferred embodiment of the invention, certain assumptions and terms that are used in the following description are set forth below:

### MultiProcessor (MP) system

A computer system that simply contains more than one CPU. Particularly, an MP system as used herein refers to a tightly coupled MP system, in which a commonly addressable memory is shared by all of the CPUs.

### Parallel processing system

An MP system in which all CPUs are executing cooperatively the work from one or a few user programs.

### Base computer system

Is the computer system needed to carry out a simulation, i.e., where the simulating program is executed.

4

Process

The activation of a program on a computer system. It is considered a unit of execution for the operating system which is controlling the operation and resource allocation of a computer system.

Simulated CPU (processor)

A processor of a simulated MP system. Its operation is simulated by a simulating program (described below).

Simulated computer system

A computer contains one or more simulated CPU(s).

Simulated operating system

An operating system runs on a simulated computer system.

Simulating program

A computer program which simulates all (or part of) the instructions of a computer architecture. Sometimes, it can also contain organization components such as caches and input/output devices.

Simulating process

A simulating program on a base computer system.

Simulated process

The process of executing an application program on a simulated computer system.

Program Trace

An output produced by a simulation program; it contains the history of execution of a simulated process on an instruction-by-instruction basis, such as: instruction name, the memory references it generates, and other characteristics associated with the instruction.

Uniprocessor Trace

A program trace of a simulated process.

MP Trace

Set of program traces from a group of simulated processes executing an application program.

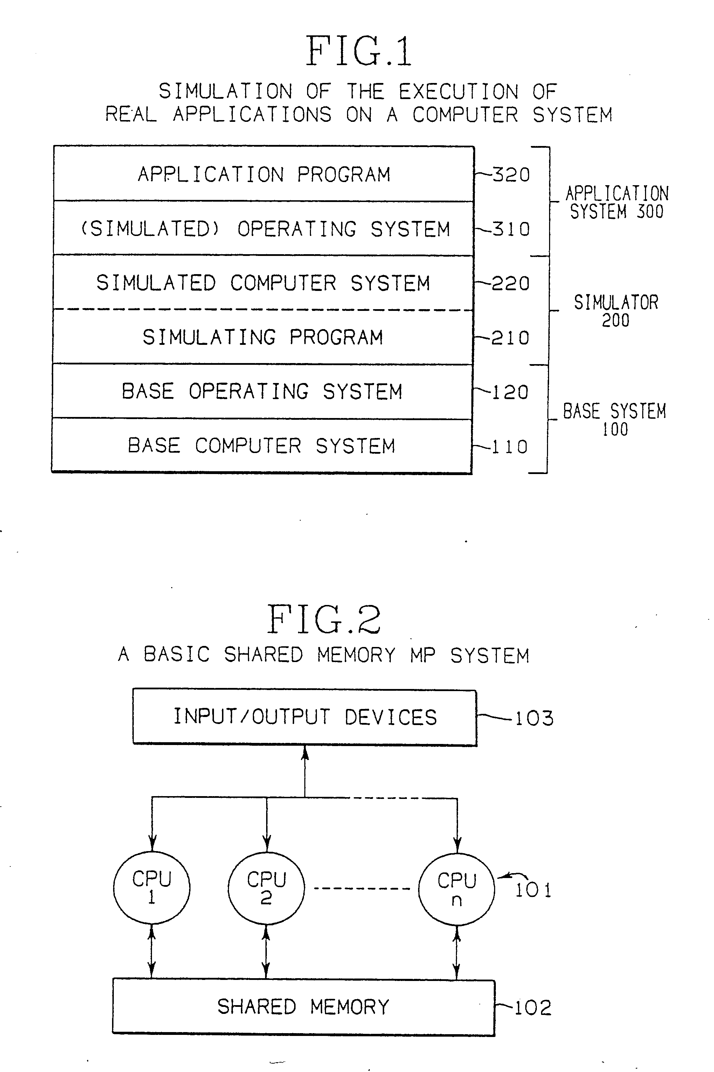

FIG. 1 is a diagram of a basic computer simulating environment. All of the components in the figure are arranged in levels, with the upper levels running on the top of the lower levels. The expression "running on", as used herein, means being properly interfaced with and provided with proper control language instructions so that the upper level program produces instructions which will be properly interpreted and executed by the lower level programs and finally executed on the base computer system. At the bottom there is a base system 100 where the simulation is carried out. It contains a computer system 110 and, usually, an operating system 120. It is assumed herein that the operating system is a multiprogrammed system which provides a set of control programs for its users to make use of the resources in 110, and allows its users to activate a group of processes, or jobs, to execute the work in an application at the same time. When the base computer system 110 is a multiprocessor (MP) system, it is also assumed that:

1. the operating system 120 is multiprocessing such that any active processes can be assigned to any available processors, or called CPUs, in 110, and

2. it has a shared memory, conventionally referred to as a tightly coupled MP system in which the memory is equally addressable by all of the CPUs. The computer simulator 200 is a software program 210 running on 120, or, provided with its own set of control programs to manipulate the resources in 110, it can be executed directly on 110. The software program 200 also contains a definition of the architecture and organization of the simulated MP system 220. For instruction level simulation, the essential components in 220 are:

a) one or more simulated CPUs,

b) an instruction set for each simulated CPU,

c) a register set for each simulated CPU, and

d) a memory.

Simulation of other components such as input and output (I/O) devices, and timing of any simulated operation can also be included in 210.

The application system 300 that is supposed to be executed on the simulated MP system 220 includes an operating system 310 which allocates the resources in 220, and an application program 320 which is running on 310. It should also be understood that the simulated computer system is a shared memory MP system.

A simulation starts by loading 310 and 320 in the simulated memory, the rest of the simulation just follows the execution, instruction by instruction, of 310 and 320 until the end of the application.

The simulator 200 that simulates the execution at a processor in 220 will be called a simulating process. An application system 300 being executed on 220 is called a simulated process.

It is noted that, for any shared memory multiprocessor system, the base operating system 120 with multiprocessing capability must include the following two features:

1. Spawning: can submit a program resulting a set of processes which can be executed by all of the CPUs in the computer system at the same time. This allows the user to create a set of simulating processes to simulate an MP system at the same time.

2. Writeable shared segments: each process has its own address space, i.e., definition of virtual memory; but a group of users can allocate a segment in each of their address spaces as shared, commonly readable and writeable. These shared segments are mainly used to allocate the shared memory of a simulated MP system.

An example for such a system is an IBM 3081 computer system running either an IBM Virtual Machine Operating System, (IBM Virtual Machine Facility/370: Introduction, GC20-1800, or IBM MVS Operating System, OS/VS2 MVS Overview GC28-0984).

FIG. 2 comprises a block diagram of a basic shared memory MP system. It has a set of n processors 101, a memory 102 addressable by all the processors, and a set of input/output devices 103 which are shared among the processors.

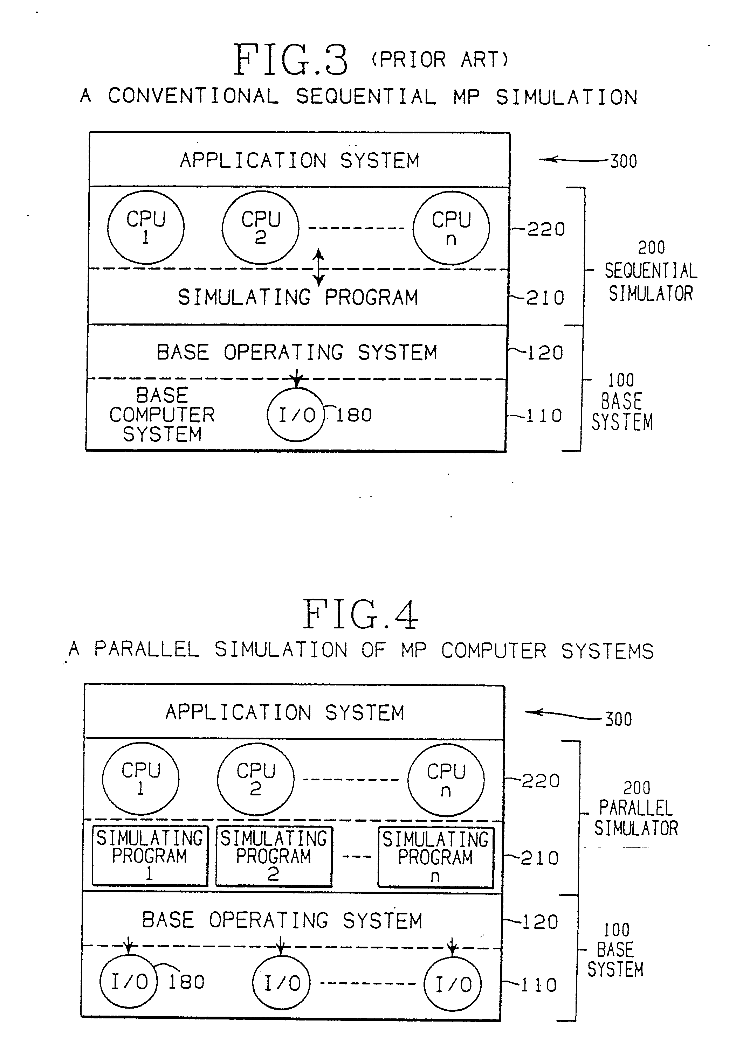

FIG. 3 comprises a diagram of a conventional prior art MP simulation organization in which the simulation of all the CPUs is taken care of by one simulating process and the traces of all the simulated processors are all written to a secondary storage 180, such as a tape device or a disk.

FIG. 4 comprises a diagram of the parallel simulation method of the present invention in which each CPU in the simulated MP system is taken care of by a separate simulating process, and each simulating process has its own secondary storage 180 to store the trace it generates. The trace from one simulated processor will be called a uniprocessor (UP)trace.

The following description of the invention comprises the following discrete components:

1) processors,

2) memory,

3) synchronization of concurrent access to shared memory, and

4) recognition and production of a full MP trace from a set of UP traces.

PROCESSORS

As depicted in FIG. 4 the present invention uses one simulating process to simulate the execution of one processor, or simulated process, in the simulated MP system 220. Assume that the simulated system 220 is architecturally the same as the base system 100, then the application system 300 can be created as a load module of the base operating system 120.

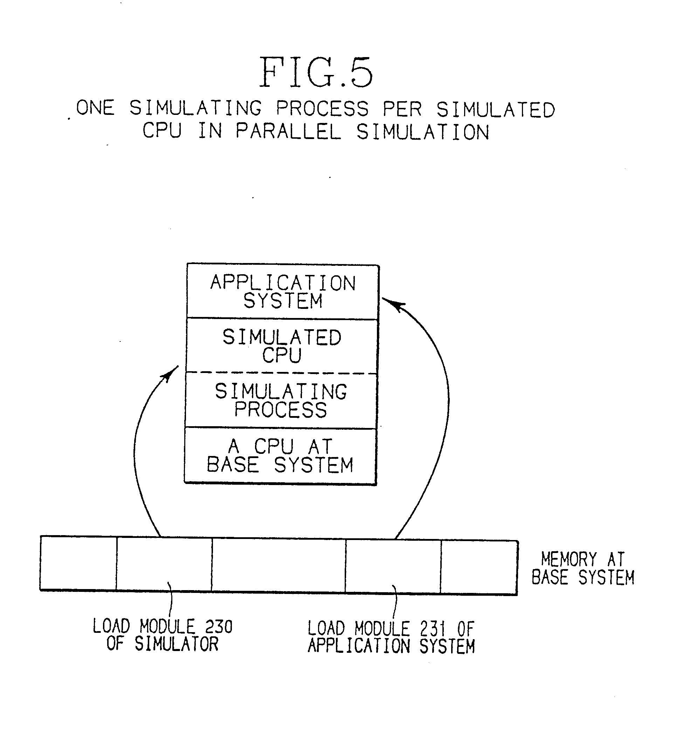

As shown in FIG. 5 an active simulating process has its own load module 230 first resident in the base memory; next, it does a load of the application load module 231 also into the base memory, from which it recognizes the beginning instruction of 231. The simulating process treats module 231 as its input data: the simulation starts from the first instruction and continues until the end of the application system 300 or otherwise on a condition, such as number of instructions, specified in the simulating process.

MEMORY

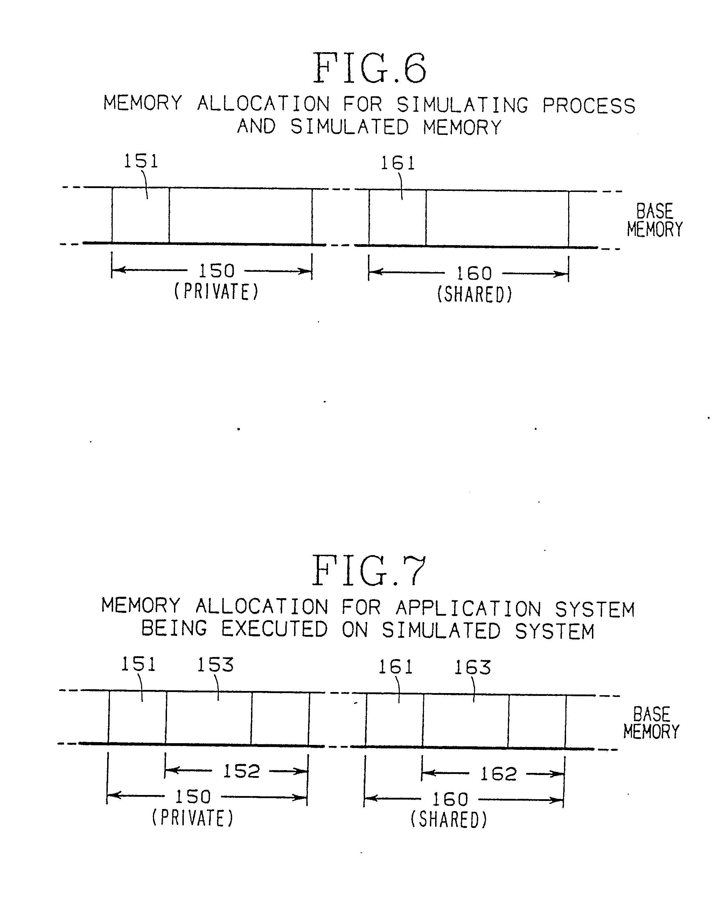

A description of storage allocation and data sharing of all of the simulated processes and simulating processes is set forth in this section. Assume that each process has its own address space, i.e., a definition of all of the memory locations it uses. FIG. 6 is a diagram of the address space of a simulating process. An address space has two regions: the private region 150 is only used by the simulating process; the shared region 160, allocated through the writeable shared segment in the base operating system 120, is readable and writeable by all of the simulating process.

Code and private data 151 of the simulating processes are loaded into the private region 150, but shared data 161 among the simulating process are loaded into the shared region 160. The rest of the storage areas, shown in FIG. 7, are respectively reserved for the simulated private memory 152 and shared memory 162 of a simulated processor. Also, FIG. 7 shows how the corresponding private and shared data of a simulated CPU, or simulated process, are respectively loaded into the private and shared regions of a simulating process. For a simulated process, its code and private data 153 are loaded into the simulated private memory 152, and its shared data 163 are loaded into the simulated memory 162. The above inclusive relation allows a simulating process to address easily any memory location of its simulated processor.

If the simulated system 220 in FIG. 4 is not architecturally the same as the base system 100, then a loader and a link editor for the simulated system must be included in the simulator. They are used to create load modules which are executable in the simulated system, storable in the base system, and can be loaded into the memory of the base system.

If the processes of a simulated MP system does not have private memory, then only 161, 162 and 163 are involved.

SYNCHRONIZATION OF CONCURRENT ACCESSES TO SHARED MEMORY

Concurrent accesses, such as read and write of a piece of data, from the simulating processes to the shared region or from the simulated processors to their simulated shared memory must be properly serialized. All these are guaranteed through the use of serialization, or atomic, instructions at the base system. For example the compare-and-swap (CS) instruction in IBM S/370 architecture. A simulating process can issue such an instruction directly at the base system. A simulated processor, however, can only execute such an instruction indirectly through its simulating process.

Due to the inclusive relation described in the previous section, a simulating process picks up such an indirect instruction from its simulated processor, and can issue an appropriate serialization instruction on the same piece of shared data in the shared region, 162 in FIG.7, at the base system. This minimizes the need for the simulating processes in the parallel simulation to communicate with each other. The simulating processes synchronize with each other only if the simulated processors want to communicate with each other.

## RECOGNITION OF A FULL MP TRACE FROM A SET OF UP TRACES

Since UP traces are generated independently and may be stored separately, without additional information, MP synchronization among the simulated processors would be lost. As a part of the present invention, a scheme to preserve all the MP synchronization events in the UP traces is described below.

The mechanism allows a simulating process to write a marker on its trace when all of the simulated CPUs have to wait for each other. First, it is necessary to choose an unused instruction at the base system which is either undefined or defined but does nothing. As an example, the branch-no-operation (NOP) in IBM S/370, described in IBM System 370 Principles of Operation, is internally a branch-on-condition (BC) instruction with the following format:

BC 0,number

Since the mask field is (always) zero, the branch is never taken, so that the number can be used from a simulated processor to notify a simulating process of a specific event.

A group of simulated processors that require a synchronization, i.e., waiting for each other , can issue such an instruction from a simulated process; each of their simulating processes will pick it up and write a special marker on the trace being generated at that time. After the parallel simulation, a recognition of the full MP trace from the set of individually stored UP traces can be carried out.

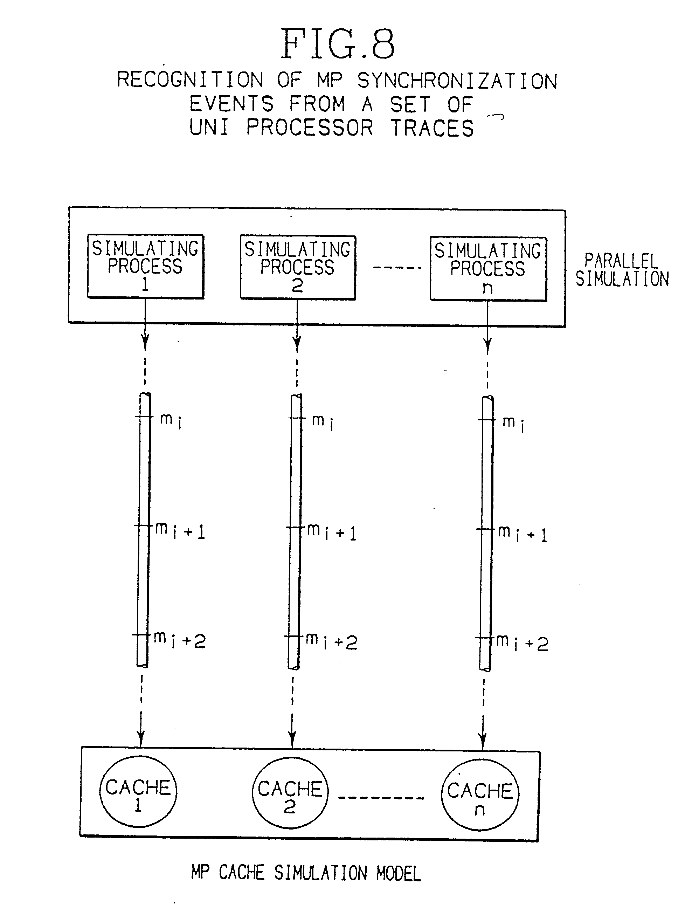

FIG. 8 is an illustration of how a set of UP traces with the above described synchronization markers can be used to reconstruct an MP trace. Assume that we use the set of UP traces to input to an MP cache model. In FIG. 8, each UP trace contains three markers: mi, mi + 1 and m1 + 2. All the caches in the MP cache model can process independently its own UP trace between mi and mi + 1. Those who reach the marker mi + 1 first have to wait for the rest before the section between mi + 1 and mi + 2 can be processed. In this way, all of the MP events in the original application that generates the MP trace can be preserved and the individual UP traces can be processed in correct sequence. By using more markers, it is possible to use the marking scheme above to record more complicated MP synchronization events on the UP traces in a parallel simulation.

The following is an example showing how a marker record is created on a program trace for a simple wait condition in an application being executed in a simulated processor:

```
In Application          In Mark Subroutine          In Program Trace
   Program

        •                       •
        •                       •
        •                       •
        •                       •
        •                       •
        •                       •

(Wait until a condition
is true)                        •                    record marks
                                                   ╱           ╲
Call Mark (10) →    BC  0,  10 →    ⟩• •⎮• •⎮  ⎮10⎮  ⎮• • •⟨
                                                 marker record of 10
        •                       •
        •                       •
(continue)                      •
        •                       •
        •                       •
        •                       •
        •                       •
```

Having described all of the major components involved with the parallel simulation procedure of the present invention, the following summarizes very succinctly all of the operations involved in carrying out the procedure on a multiprocessor base system which is itself provided with an operating system capable of multiprogrammed operation and of providing common writeable segments of memory which can be shared by the plurality of programs executable concurrently on the base system. The first two items are well known per se in the computer arts, and, as such, do not form a part of the present invention.     Given:

a) a sequential simulating program for a CPU in the simulated multiprocessor computer system.

b) an application program written to be executed on the simulated multiprocessor system.

1. Modify the simulating program for parallel simulation in the following ways.

a) one simulating program simulates the execution of one simulated CPU.

b) all of the atomic instructions that are used to perform synchronization in the simulated MP system are simulated by executing the appropriate atomic instructions at the base system where the simulating program will be executed.

c) prepare a marker program which is callable from the simulated application program/system. The execution of such program contains a special instruction as described previously. The simulating program is modified such that it writes a special marker into the trace whenever it simulates such an instruction.

2. Allocating of resources at the base MP system for parallel simulation.

a) Each simulating program is treated as an independently executable job in the MP base system so that multiple simulating programs can be simultaneously run on multiple CPUs at the base MP system. This is possible because the Operating System at the base MP system is multiprogrammed.

b) The shared memory of the simulated MP system is allocated on the shared memory of the base MP system (via the mechanism diagrammatically described in FIG. 6).

c) Allocate for each simulating program an independent output device; e.g., tape or disk, to store the execution trace of each simulated CPU as indicated schematically in FIG. 4).

3. Perform a parallel simulation incorporating the following steps:

a) Run as many copies of the simulating program on the base system at the same time as there are CPUs in the system being simulated. Each simulates the execution of one processor in the simulated system.

b) Run the application system on the top of each simulating process as set forth with respect to FIGS. 5 and 7.

c) Produce one output device for each simulating program as shown and described with reference to FIG. 4 on its assigned output device.

d) Record synchronization events in each UP trace according to the scheme that was described previously with request to FIG. 8.

e) After a parallel simulation organize the set of individual UP traces for the overall MP simulation model is to chronologically line up the synchronization events in the various traces whereby the instruction between the individual simulated processors may be analyzed.

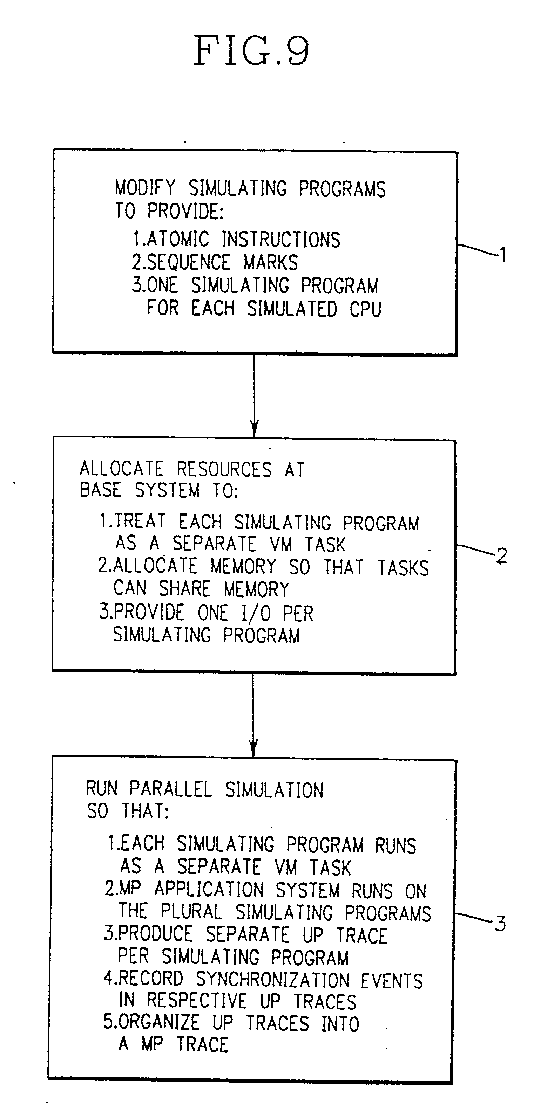

FIG. 9 is a condensed version of the above processor wherein each block represents one of the three principal operations involved in the overall process. The figure is believed to be self explanatory when considered in conjunction with the above synopsis of the procedure as well as the preceding detailed explanation.

While certain examples of existing programs for the individual simulating programs and for the modified multiprogrammed VM base operating system have been used, it will be readily appreciable that those skilled in the art could readily produce other individual simulating programs and multiprogrammed operating system which would operate similarly to the herein described embodiment without departing from the spirit and scope of this invention.

EXAMPLE

The herein disclosed parallel simulation procedure has been implemented in a multiprocessor simulation tool called PSIMUL. It runs on the IBM VM/SP operating system installed on an IBM 3081 multiprocessor base system.

PSIMUL is a general performance tool for parallel processing systems. It has been utilized in experimental performance analysis for an experimental multiprocessor system called RP3, described in an article by G. F. Pfister, W. C. Brantley, D. A. George, S. L. Harvey, W. J. Kleinfelder, K. P. McAuliffe, E. A. Melton, A. Norton, and J. Weiss entitled "The IBM Research Parallel Processor Prototype (RP3): Introduction and Architecture", IEEE, Proceedings, ICCP 1985 (Aug. 1985) pp 764-771, PSIMUL has been used in the following ways: First, it has been used to characterize the applications going to be executed on the RP3 machine. Second, the traces of applications have been used to evaluate the components of the machines, e.g., a cache. Third, PSIMUL traces have been used to drive a network simulation model described in an article by V. A. Norton and G. F. Pfister "A Methodology for Predicting Multiprocessor Performance", IEEE, Proceedings, ICCP 1985 (Aug. 1985) pp 772-781, to obtain network performance data from real applications instead of from random-number generators.

There will now follow a brief description of the various programs used in performing the parallel simulation (PSIMUL) of the present invention. As will be apparent from the previous discussion they are all relatively well know blocks organized in the manner set forth herein and modified as described.

## A) VM/SP SYSTEM

This is the block labelled 120 of FIG. 4. The multiprogramming operating system for PSIMUL is a regular S/370 VM/SP operating system.

## VM:

a) Auto-logging: A privileged userid can auto-log another userid to execute a designated program.

b) Writeable shared Segments: One or more segments can be declared commonly as shared, readable and writeable, by a group of userids in each of their address spaces such that, at run time, only a single copy of these segments exists in the real memory.

c) Data loading: A user can specify the address range(s) where a program and its data are loaded.

The base system that has been used to run PSIMUL is an IBM System 3081 model K. It is a dyadic system with two CPUs. PSIMUL can effectively use a base system with more CPUs, but it can be run on any S/370 uniprocessor system, such as an IBM 4381.

## B) A SEQUENTIAL SIMULATING PROGRAM

Any S/370 sequential simulating program (SS) can be used as the simulating program in block 210 of FIG. 4. For example the "WASHCLOTH" program referenced earlier would be suitable. It traces the execution of application programs on a subroutine base, i.e., the part of a user program to be traced must be put into a subroutine so that it will be loaded by the sequential simulator into the memory to be simulated. The simulation always starts from the beginning of the subroutine, and the simulation length is either the size of the whole subroutine or a number of instructions in the subroutine specified by a user.

Since the main user program, SS, and the subroutine being simulated are in the same address space of a userid, the address contents are consistent before and after the simulation, i.e., all the changes made to user data during the simulation are reflected in the address space.

The SS does not run with any S/370 timer, i.e., it only simulates the execution of an instruction but makes no timing of how long the instruction takes to execute in the system simulated. This may be sufficient for simulating a uniprocessor system, but is not enough for an MP system. Synchronization of simulated CPUs in an MP trace is discussed later.

In principle, the SS can trace any program that can be compiled and translated into S/370 machine code; however, up to this point, all of the applications simulated have been written in FORTRAN. Other languages may require slightly different interfaces.

## PARALLEL SIMULATION

In VM, parallel execution of an application is achieved by spawning a number of userids to execute the work in the application. If the execution of the application at each userid is called a user process, parallel simulation of the application is created by inserting a SS to simulate a user process at each userid. This is done by including a call of SS in a parallel section of the application. During the simulation, there are two layers of activities on the top of a userid: SEMUL and the simulated CPU.

SS in action will be called a simulating process (SP). A user process will also be called a simulated CPU. The trace of a simulated CPU in an MP simulation will be called a UP trace and the set of UP traces together will be called an MP trace.

As an extension of SS, PSIMUL structurally includes all the functions of SS. The additional facilities for parallel simulation were described above and will be synopsized later.

Since SS only simulates S/370 user instructions, any privileged or unsupported instructions that appear in a parallel program require special handling. PSIMUL recognizes these special requests through the use of the S/370 instruction: NOP (branch no operation), which was described previously .

## D) MP TRACES

The MP trace from a sequential simulation of an MP system is usually stored in a file in the order the simulator generated. Although this is not necessarily the only order of execution in the simulated MP system, as long as one obeys it, the synchronization among the CPUs can be correctly coordinated. In a parallel simulation, however, the traces of all the simulated CPUs may be stored in several files. Without any special action, synchronization or order of updating shared data among all of the simulated CPUs will be lost in individual files as briefly described previously.

PSIMUL provides a subroutine called MARK (which was described previously). Wherever it is called in a parallel program, PSIMUL will put a special marker, called a marker record, on the trace. Later on, these records allow any use of the traces to recreate a full MP trace, with correct execution order, from files of UP traces.

If the simulation is performed by a sequential simulator, the whole process must at least be gated by the trace writing step. For example, even if the I/O time and the CPU time at the base system can be completely overlapped, the simulation time is at least the time taken to write the trace out to an I/O device. One problem is where and how to efficiently store the huge volume of traces generated without being significantly delayed by the trace writing step.

A PSIMUL user can set up the following configurations of trace output in a parallel simulation:

This is very straightforward: every simulating process (SP), i.e., userid, is assigned a dedicated I/O 180 device to store the trace it generates. FIG. 4 clearly indicates a parallel simulation with direct output to as many I/O devices 180 as there are simulated CPUs 220. This arrangement is so simple that all the SPs are essentially independent of each other.

PSIMUL allows a user to specify a set of input parameters to carry out a parallel simulation; and other than the traces, a user can also obtain a summary of performance data. Since PSIMUL is written in a high level language, the information in the summary can be easily adapted to a user's need.

## E) SIMULATION OUTPUT

Since one of the purposes of PSIMUL is to study the memory access patterns of parallel programs, the summary file will contain information mainly about memory references of each simulated process (CPU). Similar information for a routine or a piece of data can also be produced if a user provides their address ranges according to the load map.

Since all of the userids under VM/ are executing the same load module of a parallel program, they have the same load map. This enables PSIMUL to track, at all simulated CPUs, the activities of a piece of code or data during the parallel simulation.

A user supplies the following information:   ·

-Length of simulation: number of instructions to be traced or the whole user program to be traced.
-Tracing: simulation with or without collecting the trace.
-Trace output: tape or disk to store the trace.
-Number of tapes to be filled and tape numbers.
-The addresses of sections of codes to be tracked.
-The addresses of sections of data to be tracked.

A trace is broken down into records of thousands of bytes; each record contains many sub-records. The first sub-record is an ID of a user process; the remaining sub-records are instructions or memory references of the following format:
-Types - instruction, special instruction, or memory reference.
-Memory references - instruction fetch, data fetch, and data store.
-Address of instruction or memory reference. Summary file Comprises information collected at a simulated CPU at the end of a simulation:
-Number of instructions traced.
-Number of each type of CPU references into types.

-A list of all the active S/370 op-codes simulated. Count and percentage of occurrence per op-code. Memory reference activity for each op-code. Number and percentage of instructions executed for every instruction range specified in the input file.

-Number and percentage of memory references generated for every data range specified in the input file.

It has been found that MP simulation is a highly parallel process. First, functionally there is no interaction between the SPs. Second, the frequency of synchronization among the user processes is reduced by a factor of 300.

The Table below shows the real speedup, as measured in total elapsed time in experimental runs using PSIMUL, when simulating up to four CPUs, on the two real CPUs at the base system: (on an IBM 3081-2)

```
nCPU      1 2 3 4
speedup   1 1.99 2.28 2.38
```

TABLE 1

The Table indicates that the parallel simulation is limited by the two CPUs in IBM 3081; otherwise the speedup is expected to be close to the number of CPUs at the base system. We plan to verify this on an IBM 3084, a 4-way MP system.

In the simulation of one CPU, one CPU of the base system is 80% utilized; the other is idle. In the simulation of 2 CPUs, PSIMUL has a speedup factor of nearly 2, i.e., the two CPUs in IBM 3081 can generate an MP trace of two millions instruction in 1 minute. Although both CPUs are only 80% utilized in the two-way simulation, they are almost saturated in the simulation of a 4-way MP system. The gain of speedup beyond 2-way is due to the overlapping of the CPU time and I/O time at the base system.

## CONCLUSIONS

A methodology has been described herein for speeding up the simulation of an MP system by breaking the conventionally sequential process into a parallel process. The contribution of Parallel Simulation is twofold: Fist, PSIMUL is a useful tool for studying and evaluating parallel systems. It produces information, from performance statistics to detailed traces, of how a parallel program is executed on a parallel system. Second, PSIMUL is itself a complicated parallel application with several distinguished features in parallel programming, e.g., all the simulating processes are mostly independent of each other, but they are all CPU and I/O bound. A successful parallel simulation requires a careful allocation of system resources at the base system.

Simulation of MP systems is both computation and I/O intensive. Parallel simulation is therefore a way of reducing the simulation time and generating long traces when the simulation is performed on an MP system. Since the trend is for more CPUs in most of the computers today, we think that parallel tech-niques are the choice to significantly improve existing sequential simulators.

Although the herein described implementation of PSIMUL relies on the system, actually a parallel simulation system only requires an environment with the following four ingredients:

-Multiprogramming - A user can activate a group of processes, each of which simulates a CPU.

-Shared memory - A commonly writeable storage are for the synchronization of simulating processes, and for the simulation of a shared-memory MP system.

-Multiprocessing - An operating system allows the concurrent execution of user process on all of the CPUs at the base MP system.

-The base system should also provide appropriate synchronization instruction(s) for the current accesses of a memory location, e.g., compare-and-swap.

The setup of a parallel simulation may appear to be quite complex but actually can be as close to a sequential simulation as possible. Shared memory at the base MP system is important and has been extensively used in PSIMUL to control the SPs, to centralize the information gathered and to facilitate a user to manage the output of a simulation.

PSIMUL is a powerful tool for the study of multiprocessing system architectures and for evaluating, using application traces, many components of a highly parallel system. Moreover, PSIMUL can be used as a framework for other more sophisticated parallel simulation systems.

In summary thesalient features of the present invention which are thought to be novel are:

a) the provision of a separate simulating program for each CPU being simulated.

b) the provision of a separate output device for each simulating program to record its own trace.

c) the provision of atomic instructions in the simulating programs which will run as an atomic instruction on the base operating instruction.

d) the provision of common/shared writable segments in the base memory which can be shared between the varians simulating programs and

e) the provision of an overall system organization where a simulated N-way MP system will require N simulating programs running in parallel as N separate tasks on a multiprogrammed base system, said base system preferably being, itself, a multiprocessor system.

## Claims

1. Method for the parallel simulation of a multiprocessor computing system on a base system including at least one CPU, a main memory, an operating system resident in said system which provides for multiprogrammed operation of said system whereby a plurality of jobs or programs may execute concurrently,
said operating system including a further resident memory management facility allowing said plurality of programs to allocate commonly writable shared segments in said memory,
characterized by the steps of:
providing in the system a separate sequential simulating program for each CPU of the multiprocessor being simulated,
providing in the system a separate I/O device for each simulating program in the base system to produce a uniprocessor trace for that simulating program,
providing in the system for the recording of synchronization events in the uniprocessor traces to record where and when one processor must wait for the execution of an instruction(s) of one or more other processors to be completed before proceeding with the execution of its own task sequence.

2. A method for the parallel simulation of a multiprocessor computer system as set forth in Claim 1 including:
providing in the individual simulating programs a facility for executing atomic instructions in the base system.

3. A method for the parallel simulation of a multiprocessor computer system as set forth in Claim 2 including:
utilizing said atomic instructions in the simulating programs which are directly executable on the base system to maintain the proper sequencing of memory access to shared memory space between the simulated processors.

4. A method for the parallel simulation of a multiprocessor computer system as set forth in one of the Claims 1-3 wherein the base computer system includes a multiprogrammed operating system, said method including:
running each of said plurality of simulating programs on said base multiprogrammed system as an individual user task.

5. A method for the parallel simulation of a multiprocessor computer system as set forth in Claim 4 wherein the base computer system is itself a multiprocessor computer system, said method including running the user tasks in parallel on the multiple CPUs of the base system as separate tasks assigned by the multiprogrammed operating system whereby the speed up of the simulation is proportional to the number of processors in the base system.

6. A method for the parallel simulation of a multiprocessor computer system as set forth in Claim 4 or 5 wherein the step of providing for synchronization events in the simulated system includes:
inserting a sequence mark in the application program which is callable at the base system whereby a special synchronization marker is written into affected uniprocessor traces to allow the occurrence of the same marker in two or more traces to be used in processing an overall MP trace.

7. A method for the parallel simulation of a multiprocessor computer system as set forth in one of the Claims 4-6 including:
running a multiprocessor application system on top of the simulated CPU, simulating programs and base multiprogrammed system respectively,
producing one uniprocessor output trace for each simulating program on its own assigned I/O device,

13

recording synchronization events in the individual output traces as specified, and,

producing a final multiprocessor output trace from the individual uniprocessor output traces to align related synchronization events.

8. Electronic data processing system (the base system) including at least two CPUs, a main memory, and an operating system resident in said system which provides for the concurrent execution of user processes on all of the processors of the base system,

characterized in that

a facility is provided which allows the high speed simulation of a multiprocessor computer system, including:

a facility in said operating system which allows multiprogrammed operation of said system whereby a plurality of said user processes execute as separate programs on said system,

a resident memory management facility allowing said plurality of programs to allocate commonly writable shared segments in said memory,

a facility in said operating system which provides synchronization instructions for marking synchronization events in output traces produced by said simulation,

a separate sequential simulating program for each processor of the multiprocessor being simulated which is adapted to run concurrently on said base system as a separate user task and a multiprocessable application system adapted to run on and be distributed across said plurality of simulating programs.

9. An electronic data processing system adapted for the parallel simulation of a multiprocessor computer system as set forth in Claim 8 including:

a separate I/O device dedicated to serving each simulating program connected to said base system for recording a separate output uniprocessor trace as produced by that simulating program.

10. An electronic data processing system adapted for the parallel simulation of a multiprocessor computer system as set forth in Claim 8 or 9 including:

a facility for specifying atomic instructions in a simulating program which are directly executable on the base system whereby accesses to common shared segments of the memory are controlled.

11. A method for performing a parallel simulation of one or more application programs running on a simulated multiprocessor system, said method including:

executing, at a base system where the simulation is performed, a simulating program for each processor in the simulated multiprocessor system,

each simulating program simulating one processor and storing the trace generated by the simulation on its own dedicated I/O device, so that all of the resources in the base system including a plurality of CPUs may be optimally used,

providing for the sharing of data among the simulated processor through a commonly addressable segment in the memory of the base system, and

using atomic instructions in the simulating programs to serialize concurrent accesses to shared memory locations in the simulated multiprocessor system, which use is guaranteed by using the same atomic instructions at the base system, and

inserting synchronization records into the individual uniprocessor traces by the program as implemented for each simulated CPU whenever it is found that an operation in one simulated CPU is waiting for the completion of an operation in another simulated CPU, whereby any synchronization events among the processors in the simulated multiprocessor system are recorded.

12. A parallel simulation method as set forth in Claim 11 including:

recreating a full multiprocessor trace, for the simulated multiprocessor system with correct execution sequencing from the set of said individual uniprocessor traces each of which is generated by the simulating programs for the various individual simulated multiprocessors.

# FIG.1

SIMULATION OF THE EXECUTION OF
REAL APPLICATIONS ON A COMPUTER SYSTEM

| | | |
|---|---|---|
| APPLICATION PROGRAM | ~320 | APPLICATION SYSTEM 300 |
| (SIMULATED) OPERATING SYSTEM | ~310 | |
| SIMULATED COMPUTER SYSTEM | ~220 | SIMULATOR 200 |
| SIMULATING PROGRAM | ~210 | |
| BASE OPERATING SYSTEM | ~120 | BASE SYSTEM 100 |
| BASE COMPUTER SYSTEM | ~110 | |

# FIG.2

A BASIC SHARED MEMORY MP SYSTEM

INPUT/OUTPUT DEVICES ~103

CPU 1       CPU 2    ------    CPU n    101

SHARED MEMORY ~102

# FIG.3 (PRIOR ART)

## A CONVENTIONAL SEQUENTIAL MP SIMULATION

# FIG.4

## A PARALLEL SIMULATION OF MP COMPUTER SYSTEMS

# FIG.5
## ONE SIMULATING PROCESS PER SIMULATED CPU IN PARALLEL SIMULATION

APPLICATION SYSTEM

SIMULATED CPU

SIMULATING PROCESS

A CPU AT BASE SYSTEM

MEMORY AT BASE SYSTEM

LOAD MODULE 230 OF SIMULATOR

LOAD MODULE 231 OF APPLICATION SYSTEM

# FIG.6

MEMORY ALLOCATION FOR SIMULATING PROCESS
AND SIMULATED MEMORY

# FIG.7

MEMORY ALLOCATION FOR APPLICATION SYSTEM
BEING EXECUTED ON SIMULATED SYSTEM

# FIG.8
## RECOGNITION OF MP SYNCHRONIZATION EVENTS FROM A SET OF UNI PROCESSOR TRACES

SIMULATING PROCESS 1

SIMULATING PROCESS 2

SIMULATING PROCESS n

PARALLEL SIMULATION

$m_i$

$m_{i+1}$

$m_{i+2}$

$m_i$

$m_{i+1}$

$m_{i+2}$

$m_i$

$m_{i+1}$

$m_{i+2}$

CACHE 1

CACHE 2

CACHE n

MP CACHE SIMULATION MODEL

# FIG.9

MODIFY SIMULATING PROGRAMS
TO PROVIDE:

    1.ATOMIC INSTRUCTIONS
    2.SEQUENCE MARKS
    3.ONE SIMULATING PROGRAM
      FOR EACH SIMULATED CPU

—1

ALLOCATE RESOURCES AT
BASE SYSTEM TO:

    1.TREAT EACH SIMULATING PROGRAM
      AS A SEPARATE VM TASK
    2.ALLOCATE MEMORY SO THAT TASKS
      CAN SHARE MEMORY
    3.PROVIDE ONE I/O PER
      SIMULATING PROGRAM

—2

RUN PARALLEL SIMULATION
SO THAT:

    1.EACH SIMULATING PROGRAM RUNS
      AS A SEPARATE VM TASK
    2.MP APPLICATION SYSTEM RUNS ON
      THE PLURAL SIMULATING PROGRAMS
    3.PRODUCE SEPARATE UP TRACE
      PER SIMULATING PROGRAM
    4.RECORD SYNCHRONIZATION EVENTS
      IN RESPECTIVE UP TRACES
    5.ORGANIZE UP TRACES INTO
      A MP TRACE

—3